# FASCICULE DE BREVET EUROPEEN

(11) **EP 3 154 082 B1**
(45) Date de publication et mention de la délivrance du brevet: **21.03.2018**
(21) Numéro de dépôt: 16191935.2
(22) Date de dépôt: 30.09.2016
(51) Int. Cl.: H01L 23/427, H01L 23/373

(54) **STRUCTURE DBC AMELIOREE DOTEE D'UN SUPPORT INTEGRANT UN MATERIAU A CHANGEMENT DE PHASE**
VERBESSERTE DBC-STRUKTUR, DIE MIT EINEM TRÄGERELEMENT AUSGESTATTET IST, IN DAS EIN MATERIAL MIT PHASENUMWANDLUNG EINGEBAUT IST
IMPROVED DBC STRUCTURE PROVIDED WITH A MOUNTING INCLUDING A PHASE-CHANGE MATERIAL

(30) Priorité: 09.10.2015 FR 1559632
(43) Date de publication de la demande: 12.04.2017
(73) Titulaire: COMMISSARIAT À L'ÉNERGIE ATOMIQUE ET AUX ÉNERGIES ALTERNATIVES, 75015 Paris (FR)
(72) Inventeur: SOUPREMANIEN, Ulirch, 38160 SAINT MARCELLIN (FR); OLLIER, Emmanuel, 38000 GRENOBLE (FR); QUENARD, Sébastien, 38700 LE SAPPEY EN CHARTREUSE (FR); ROUMANIE, Maryline, 38500 COUBLEVIE (FR); SZAMBOLICS, Helga, 38000 GRENOBLE (FR)
(74) Mandataire: Brevalex

(56) Documents cités:
- DE-A1-102010 041 714
- US-A1- 2012 048 515

## Description

### DOMAINE TECHNIQUE ET ART ANTÉRIEUR

La présente demande a trait au domaine de la microélectronique et concerne plus particulièrement les structures configurées à la fois pour réaliser une interconnexion d'un dispositif électronique et permettre de réaliser une dissipation thermique de la chaleur générée par ce dispositif électronique.

Dans l'électronique de puissance, afin d'interconnecter un dispositif électronique tel qu'une puce, un circuit intégré, ou un ensemble de composants, il est connu d'utiliser des structures d'interconnexion de type DBC pour « (DIRECT BONDED COPPER), dont le rôle est en outre d'assurer l'isolation électrique des composants et de permettre d'évacuer la chaleur générée par le dispositif électronique.

Une structure DBC est typiquement formée d'un substrat à base d'un matériau diélectrique, généralement céramique, sur lequel une ou plusieurs zones conductrices, généralement à base de cuivre sont disposées. Le substrat peut être directement lié au cuivre. Un dispositif électronique à interconnecter, par exemple un circuit ou une puce ou un composant et dont on souhaite limiter l'échauffement est alors disposé en contact d'au moins une des zones de cuivre sur une première face du substrat. Un élément dissipateur thermique est généralement disposé sur une deuxième face du substrat opposée à la première face.

Le document US 2012/0048515 A1, présente une structure de type DBC sous forme d'un substrat diélectrique dont les faces supérieure et inférieure sont recouvertes respectivement d'une première et d'une deuxième couche de cuivre.

Pour permettre d'améliorer le refroidissement d'un composant disposé sur la première couche de cuivre du côté de la face supérieure du substrat, un système de dispense de matériau à changement de phase est prévu au niveau de la face arrière de la structure. Ce matériau est délivré sous forme de gouttelettes liquides qui lorsqu'elles entrent en contact avec la deuxième couche de cuivre, se vaporisent ce qui permet de refroidir le composant.

Un tel système pose des problèmes de complexité de mise en oeuvre, de robustesse, et d'encombrement.

### EXPOSÉ DE L'INVENTION

L'invention proposée vise à remédier à ces inconvénients.

Selon un aspect, la présente invention prévoit une structure, en particulier de type DBC, de connexion et de dissipation de la chaleur issue d'un dispositif électronique, cette structure comprenant un support isolant revêtu d'au moins une zone conductrice apte à accueillir le dispositif électronique, la zone conductrice étant en contact avec une première face du support, le support isolant comprenant une enveloppe de matériau diélectrique définissant une cavité remplie d'un matériau à changement de phase.

Avec une telle structure on limite des pics d'échauffement du dispositif électronique lorsque celui-ci fonctionne hors de son régime permanent tout en réalisant une évacuation thermique lorsque le dispositif fonctionne en régime permanent. Une telle structure permet à la fois de réduire la température maximale du dispositif mais aussi de réduire ces variations thermiques. Une telle structure permet d'augmenter la durée de vie du dispositif électronique qui est en partie liée à sa tenue aux variations thermiques répétées.

Une telle structure est par ailleurs compacte et permet de réaliser une dissipation thermique au plus près du composant, le chemin thermique à parcourir entre le composant susceptible d'échauffement et la structure permettant la dissipation thermique étant réduit.

Le support isolant peut être revêtu d'au moins une autre zone conductrice en contact avec une deuxième face du support opposée à la première face, l'autre zone conductrice étant, quant à elle, apte à accueillir un élément dissipateur thermique, par exemple doté d'ailettes et/ou d'un réseau fluidique.

Avantageusement, à l'intérieur de la cavité, l'enveloppe de matériau diélectrique peut être revêtue d'une couche de matériau conducteur thermique, en particulier métallique.

Une telle couche peut être prévue pour permettre d'homogénéiser les échanges thermiques autour de la cavité.

Avantageusement, la structure comprend également un ou plusieurs piliers qui s'étendent dans la cavité et sont configurés pour soutenir l'enveloppe de matériau diélectrique.

De préférence, le support isolant électrique est agencé de telle sorte que le matériau diélectrique de l'enveloppe s'étende sur la première face, la deuxième face et sur des faces latérales disposées entre la première face et la deuxième face.

Le support forme ainsi une enveloppe ou enceinte diélectrique réalisant un contour fermé autour du matériau à changement de phase. L'intégration du matériau à changement de phase (MCP) peut se faire au sein même d'un diélectrique sans qu'une couche de collage ou de fermeture supplémentaire soit obligatoire.

Du fait de l'homogénéité de matériau diélectrique encapsulant le matériau à changement de phase on limite d'éventuels phénomènes de délamination.

Selon un autre aspect, la présente invention prévoit également un procédé de réalisation d'une structure de connexion et de dissipation de la chaleur issue d'un dispositif électronique, la structure comprenant : un support diélectrique revêtu d'au moins une zone conductrice en contact avec une première face du support, la zone conductrice étant prévue pour accueillir le dispositif électronique, le support isolant comportant une enveloppe en matériau diélectrique délimitant une cavité remplie d'un matériau à changement de phase, le procédé comprenant des étapes de :
a) formation d'un support isolant comprenant une enveloppe de matériau diélectrique définissant une cavité, une ou plusieurs ouvertures étant formées dans l'enveloppe de sorte à permettre un accès à la cavité,
b) remplissage de la cavité à l'aide d'un matériau à changement de phase introduit par le biais d'au moins une desdites ouvertures.

Selon une possibilité de mise en oeuvre du procédé, la cavité formée à l'étape a) peut être remplie d'un matériau sacrificiel, que l'on retire, entre l'étape a) et l'étape b), puis l'on remplace à l'étape b) par le matériau à changement de phase.

La mise en oeuvre d'un matériau sacrificiel permet de maintenir la forme de la cavité lors de la réalisation de la structure DBC, tout en évitant d'exposer le matériau à changement de phase à d'éventuelles étapes de procédé nécessitant un budget thermique important.

Selon une possibilité de mise en oeuvre du procédé, l'étape a) peut également comprendre la formation d'un ou plusieurs piliers de soutien de l'enveloppe de matériau diélectrique, le ou les piliers s'étendant dans la cavité entre la première face et une deuxième face du support isolant opposée à la première face.

De tels piliers sont configurés pour réaliser un soutien mécanique à l'enveloppe de matériau diélectrique et peuvent permettre de maintenir la forme de la cavité au cours du procédé de réalisation ainsi que lorsque le matériau à changement de phase est sous forme liquide.

Selon une possibilité de mise en oeuvre, le procédé peut comprendre une étape consistant à revêtir l'intérieur de la cavité d'une couche de matériau conducteur thermique, en particulier métallique.

Une telle couche métallique peut être prévue à base d'un matériau présentant une affinité avec le matériau à changement de phase. Par « affinité » on entend en particulier que la couche métallique peut être prévue à base d'un matériau présentant une bonne mouillabilité avec le matériau à changement de phase. Dans ce cas, on améliore également le remplissage effectué à l'étape b).

Le procédé peut comprendre préalablement à l'étape b), une étape de formation d'ouvertures dans l'enveloppe diélectrique du support.

Selon une possibilité de mise en oeuvre du procédé, au moins une ouverture parmi lesdites ouvertures est formée à travers une face latérale du support isolant. Par face latérale on entend une face qui s'étend entre la première et la deuxième face.

En variante ou en combinaison, on réalise au moins une ouverture traversant la première face ou deuxième du support isolant.

Après l'étape b) de remplissage par un matériau à changement de phase, le procédé peut comprendre en outre, après l'étape b), la formation d'un ou plusieurs éléments de bouchage desdites ouvertures.

Le procédé peut comprendre en outre au moins une étape de formation d'une zone conductrice sur le support isolant.

Cette étape peut être réalisée par exemple par assemblage direct ou avantageusement à l'aide d'un dépôt PVD.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un exemple de structure de type DBC mise en oeuvre selon un mode de réalisation de la présente invention et comportant un support diélectrique à l'intérieur duquel une cavité remplie de matériau à changement de phase est agencé,
- les figures 2A-2B illustrent la réponse en température d'une architecture dotée d'une telle structure suite à un échauffement soudain pour différentes épaisseur de matériau à changement de phase dans la cavité,
- les figures 3A-3B illustrent le remplissage de la cavité par le matériau à changement de phase en se servant d'une ou plusieurs ouvertures réalisées dans une enveloppe diélectrique délimitant cette cavité,
- la figure 4 illustre une variante dans laquelle les ouvertures sont pratiquées dans l'enveloppe diélectrique et à travers une couche conductrice disposée sur une face supérieure du support diélectrique,
- les figures 5A-5B illustrent un mode de réalisation dans lequel la cavité est remplie d'un matériau sacrificiel remplacé ensuite par le matériau à changement de phase,
- les figures 6A-6B illustrent un mode de réalisation dans lequel des piliers de soutien mécanique de l'enveloppe du support diélectrique sont prévus,
- les figures 7A-7B illustrent un mode de réalisation dans lequel une fine couche métallique tapisse les parois internes de la cavité,
- la figure 8 illustrent un mode de réalisation dans lequel des bouchons de fermeture de la cavité sont réalisés dans ou en regard d'ouvertures agencées dans l'enveloppe isolante,
- les figures 9A-9I illustrent un exemple de procédé de réalisation en couches minces d'une structure DBC.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation, telle que « sous », « sur », « au-dessus », « supérieure », « inférieure », « latérale », etc. d'une structure s'appliquent en considérant que la structure est orientée de la façon illustrée sur les figures.

### EXPOSÉ DÉTAILLÉ DE MODES DE RÉALISATION PARTICULIERS

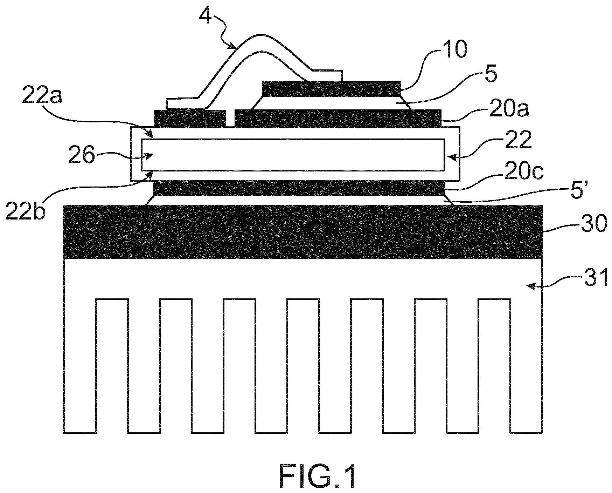

On se réfère tout d'abord à la figure 1, sur laquelle une structure de connexion et de dissipation thermique de type DBC (pour « Direct Bonded Copper ») est représentée.

La structure DBC est connectée à un dispositif électronique 1 susceptible de subir des élévations thermiques transitoires que l'on cherche à limiter. Le dispositif électronique 1 peut être en particulier une puce ou un circuit de puissance ou être doté d'au moins un composant électronique actif i.e. apte à augmenter la puissance d'un signal. Par exemple, le dispositif électronique 1 peut être doté de thyristor(s) de type GTO (de l'anglais "Gate Turn-Off Thyristor") ou de transistor(s) bipolaire(s) à grille isolée (IGBT, de l'anglais « Insulated Gate Bipolar Transistor ») ou de thyristor(s) IGCT (pour « Integrated Gate-Commutated Thyristor) ou de transistor(s) en technologie MOSFET réalisés sur un substrat.

La structure DBC comprend un support 22 isolant revêtu d'au moins une première zone conductrice 2a sur laquelle le dispositif électronique 1 est disposé.

Le dispositif électronique 1 peut être rendu solidaire de la première zone conductrice 20a par exemple par l'intermédiaire d'un matériau de soudure 5 et peut être connecté électriquement à une deuxième zone conductrice 20b par l'intermédiaire d'au moins un élément conducteur tel que par exemple un fil métallique 4. Les première et deuxième zones conductrice 20a, 20b sont disposées sur et en contact d'une face 22a du support 22 isolant et que l'on appellera « face avant » 22a ou « face supérieure » 22a.

Dans cet exemple de réalisation, une troisième zone conductrice 20c, est disposée sur et en contact d'une face 22b du support 22 isolant opposée à ladite face supérieure inférieure et que l'on appellera « face arrière » 22b ou « face inférieure » 22b.

La zone troisième conductrice 20c est reliée à un élément 31 dissipateur de chaleur. Cet élément 31 dissipateur thermique peut être formé par exemple d'une pluralité d'ailettes espacées entre elles et qui réalisent un angle non-nul, par exemple de 90°, avec les faces inférieures et supérieures du support 22 isolant. En variante, on peut prévoir une autre structure d'élément dissipateur thermique 31, par exemple une structure à canaux fluidiques s'étendant parallèlement à la face inférieure 22b du support 22. L'élément dissipateur thermique 31 peut être rendu solidaire de la zone conductrice 2c par l'intermédiaire d'un matériau de soudure 5'.

Pour permettre d'assurer la résistance mécanique de l'ensemble, on peut également prévoir une couche de soutien 30 mécanique entre la troisième zone conductrice 20c et l'échangeur thermique 31. La couche de soutien (« base plate » selon la terminologie anglo-saxonne) peut être une couche métallique réalisée par exemple en cuivre ou en aluminium.

Les faces supérieure et inférieure de la structure peuvent avoir une surface par exemple comprise entre plusieurs centaines de mm² et plusieurs centaines de cm².

Afin d'obtenir une protection thermique améliorée du dispositif électronique 1, le support 22 isolant de la structure DBC est ici sous forme d'une enveloppe ou enceinte en matériau diélectrique délimitant une cavité 25. Cette cavité 25 est remplie d'un matériau 26 à changement de phase. De préférence, le matériau 26 à changement de phase a une température de fusion située dans une plage de fonctionnement normal du dispositif électronique 1.

Le matériau diélectrique du support 22 peut être exemple du Si₃N₄, ou avantageusement un matériau céramique tel que de l'alumine ou de l'AIN.

Le matériau 26 MCP encapsulé dans la cavité 25 peut être choisi de sorte à avoir une température de changement de phase solide/liquide, comprise par exemple entre 20°C et 250°C.

Le matériau 26 MCP peut également avoir une chaleur latente supérieure à 20 kJ/kg, une chaleur spécifique massique supérieure à 100 J/K/kg, une conductivité thermique supérieure à 10 W/m/K. Le matériau 26 à changement de phase (MCP) peut être par exemple du Ga, ou de l'In ou un alliage tel que par exemple du In₉₇-Ag₃, ou du Bi₅₈-Sn₄₂, ou de l'In₅₂-Sn₄₈. Le matériau 26 MCP entouré par l'enveloppe diélectrique du support 22 permet de réaliser un écrêtage de pics de chaleur susceptible d'être dégagés par le dispositif électronique 1.

De préférence, la cavité 25 est entièrement remplie par le matériau 26 de changement de phase. Avantageusement, la cavité 25 délimitée par l'enveloppe diélectrique a des dimensions permettant de contenir un volume important de matériau 26 à changement de phase. En particulier, la cavité 25 est prévue avec une hauteur H, comprise par exemple entre 0.05 mm et 1.5 mm (mesurée parallèlement à l'axe z d'un repère orthogonal [O; x; y; z] donné sur la figure 1) adaptée en fonction d'une épaisseur prédéterminée de matériau 26 MCP pour atteindre un niveau de dissipation thermique donné. Ainsi, en fonction du niveau d'écrêtage recherché, on adapte l'épaisseur ou hauteur de matériau 26 MCP ainsi que le type de matériau MCP choisi.

L'épaisseur de matériau 26 MCP dans la cavité peut être déterminée notamment en fonction du dégagement de chaleur du dispositif électronique 1 lorsque celui-ci se trouve dans un régime permanent de fonctionnement. De préférence, l'épaisseur de matériau 26 MCP est limitée de sorte que l'élément dissipateur thermique 31 puisse réaliser sa fonction de dissipation en régime permanant.

Le tableau ci-dessous donne des épaisseurs caractéristiques pour différents matériaux 26 MCP.

| **Matériau MCP** | **Conductivité thermique (W/m/K)** | **Coefficient d'expansion thermique (1/K)** | **Densité (g/cm3)** | **Epaisseur (mm)** |
|---|---|---|---|---|
| AIN | 170 | 4.2 | 3.26 | 0.64 |
| Si₃N₄ | 70-90 | 3.4 | 3.2 | 0.32 |
| Al₂O₃ | 24 | 7.1 | 3.7 | 0.25-0.6 |

On peut prévoir de déterminer l'épaisseur de matériau 26 MCP à introduire dans la cavité de sorte que la résistance thermique du support 22 rempli de ce matériau 26 MCP soit équivalente en régime permanant à celle d'une structure DBC classique dans laquelle le support est une simple couche de matériau diélectrique. L'épaisseur de matériau 26 MCP peut être par exemple comprise entre 100 µm et 7500 µm, en particulier entre 750 µ et 7500 µm.

En régime transitoire de dégagement de chaleur du dispositif électronique 1, l'écrêtage thermique réalisé avec une telle structure à matériau 26 MCP est plus important qu'une structure DBC classique. En effet, la chaleur latente du matériau à changement de phase rentre en considération dans le stockage d'énergie et donc dans l'amortissement thermique. Par conséquent, on choisit de préférence un matériau MCP 26 ayant une chaleur latente élevée, par exemple supérieure à 20 kJ/kg.

Avantageusement, l'enveloppe diélectrique du support 22 est répartie de telle sorte que la face inférieure 22a, la face supérieure 22b et les faces latérales 22c reliant la face inférieure 22a et la face supérieure 22c sont en un même matériau diélectrique. Ainsi, du fait de la continuité de matériau entre les faces 22a, 22b et 22c celles-ci ont des propriétés thermo-physiques semblables. Cela permet de réaliser une encapsulation du matériau 26 à changement de phase tout en évitant un phénomène de délaminage. Un tel phénomène serait éventuellement susceptible d'apparaître dans certaines conditions si l'on venait par exemple remplacer la face supérieure 22a ou la face inférieure 22b par une couche de fermeture ayant des propriétés thermo-physiques différentes de celle du reste de l'enveloppe diélectrique.

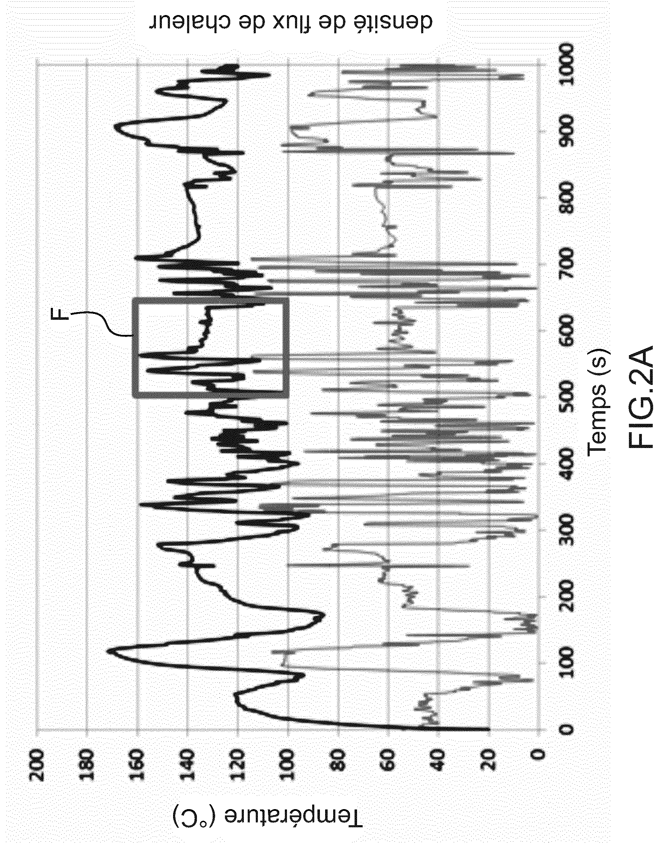

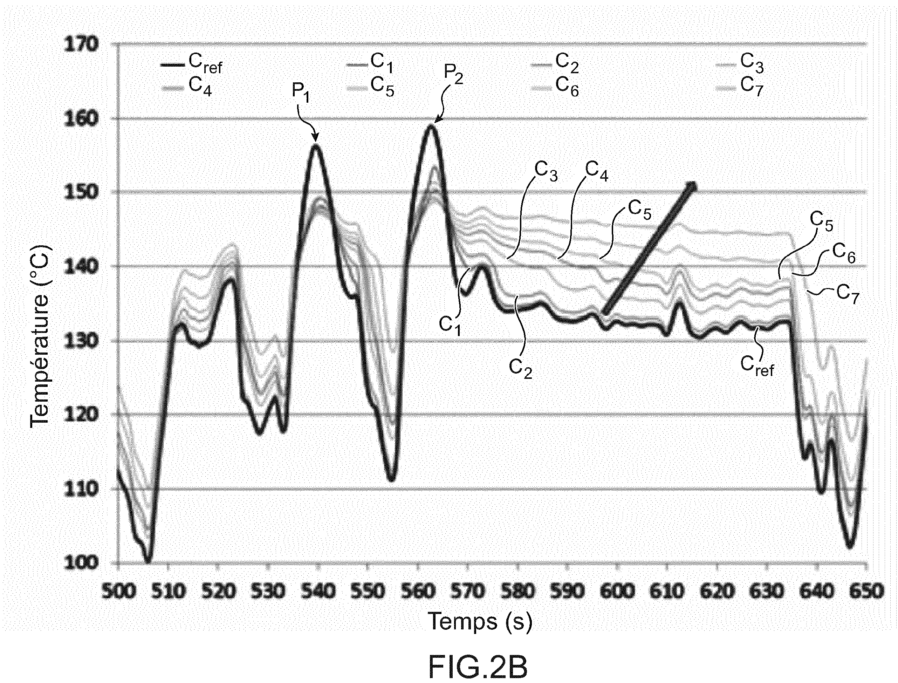

Le comportement thermique d'une architecture dotée d'une structure DBC du type de celle décrite en liaison avec la figure 1 est illustrée sur la figure 2B, cette figure donnant des exemples de courbes de températures dans une fenêtre temporelle F sélectionnée d'un flux thermique tel qu'illustré sur la figure 2A.

Sur la figure 2B différentes courbes de température C₁, C₂, C₃, C₄, C₅, C₆, C₇ pour différentes des structures avec des épaisseurs respectives de matériau à changement de phase de l'ordre de 750 µm, 1200 µm, 2500 µm, 3500 µm, 4200 µm, 5500 µm, 7500 µm. La courbe C_{ref} traduit à titre de comparaison le comportement en température d'une structure DBC classique et qui n'est pas dotée de cavité remplie de matériau à changement de phase. Comme le montrent les pics P₁, P₂, la structure décrite précédemment permet de mieux limiter des élévations soudaines de température.

Pour permettre de remplir la cavité 25 du matériau 26 à changement de phase, lors de la réalisation d'une structure DBC telle que décrite précédemment, on prévoit une ou plusieurs ouvertures dans l'enveloppe de matériau diélectrique du support 22. Les ouvertures peuvent avoir une largeur Δ par exemple de l'ordre de plusieurs dizaines ou centaines de micromètres. Par largeur on entend la plus petite dimension mesurée parallèlement à l'enveloppe de matériau diélectrique.

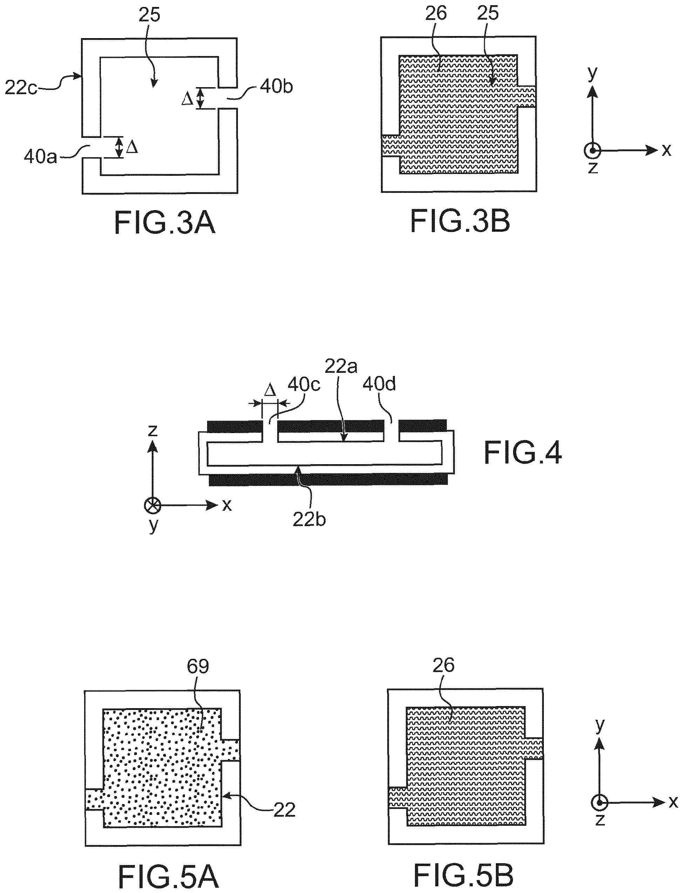

Dans l'exemple de réalisation de la figure 3A sur laquelle une cavité est représentée selon une vue de dessus, des ouvertures 70a, 70b sont pratiquées au niveau de faces latérales 22c du support isolant, par exemple par perçage laser.

On réalise le remplissage de la cavité en introduisant le matériau MCP 26 à travers au moins une de ces ouvertures (figure 3B). Ce remplissage est effectué lorsque le matériau MCP 26 est sous forme liquide c'est-à-dire dans un environnement à une température permettant de porter le matériau MCP 26 au-delà de son point de fusion. Une fois le matériau 26 MCP monté à une température supérieure au point de fusion, le remplissage est effectué. Le remplissage peut se faire par exemple par mise en pression ou en dépression à l'aide d'un système de pompage, ou simplement par gravité.

En variante ou en combinaison, on peut également prévoir des ouvertures 70c, 70d transversales au niveau de la face inférieure ou de la face supérieure du support 22. Dans l'exemple particulier illustré sur la figure 4, les ouvertures 70c, 70d traversent également une zone conductrice 2a disposée en contact avec la face supérieure du support diélectrique 22. Les ouvertures 70c, 70d peuvent dans ce cas avoir été réalisées après assemblage de la zone conductrice 2a avec le support diélectrique 22.

Des étapes à des températures très élevées, par exemple supérieures à 1000°C, telles qu'une mise en pression de bandes de matériau diélectrique, de recuit, de déliantage, de frittage, de dépôt peuvent être mises en oeuvre afin de réaliser la structure DBC.

Lors du procédé de fabrication de la structure DBC, pour pallier un éventuel problème de fluage de l'enveloppe diélectrique et éviter que la partie supérieure de l'enveloppe ne s'affaisse ou qu'une déformation de la cavité ne se produise, on peut prévoir un moyen de maintien à l'intérieur de la cavité.

Selon une possibilité de réalisation de ce moyen de maintien, on introduit un matériau sacrificiel 69 dans la cavité (figure 5A).

Le matériau sacrificiel 69 peut être un matériau apte à être décomposé, détruit ou dissous à une température élevée, par exemple supérieure à 250°C, et/ou apte à être gravé sélectivement par rapport au matériau diélectrique formant l'enveloppe de la cavité 25. Le matériau sacrificiel 69 peut être par exemple à base d'une résine photosensible ou à base de carbone.

Ensuite, le matériau sacrificiel 69 est remplacé par le matériau à changement de phase 26 (figure 5B).

Le fait de prévoir un tel matériau sacrificiel 26 lors du procédé de fabrication de la structure DBC permet également de ne pas faire subir au matériau à changement de phase 26 des étapes susceptibles de le dégrader, et en particulier des étapes lors desquelles une élévation de température importante est mise en oeuvre.

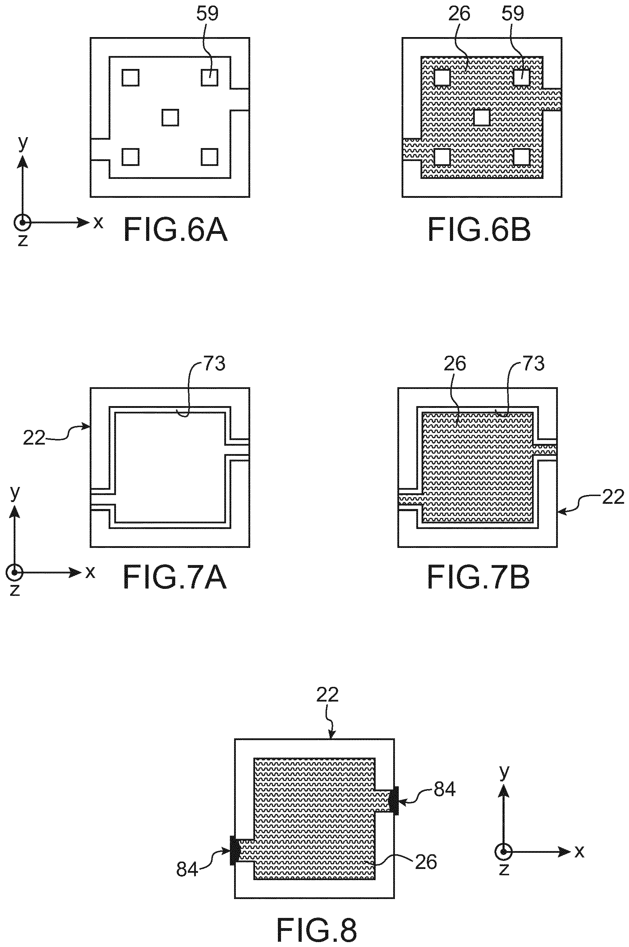

En variante ou en combinaison, on peut également prévoir un ou plusieurs piliers 59 de soutien tels qu'illustrés sur les figures 6A-6B pour réaliser un moyen de maintien en forme de la cavité 25 lors de la réalisation de la structure DBC. Les piliers 59 s'étendent dans la cavité 25 entre la face inférieure et la face supérieure du support 22 et peuvent être réalisés dans le même matériau diélectrique que celui de l'enveloppe diélectrique.

Un exemple de procédé de réalisation du support 22 isolant comprend la réalisation par coulage d'une ou plusieurs bandes de matériau diélectrique qui peuvent être ensuite découpées par laser puis empilées. En variante, on réalise un empilement par assemblage puis une découpe par exemple par laser. L'étape d'assemblage peut être réalisée sous pression par exemple comprise entre 0.1 et 10 MPa, à une température comprise entre la température ambiante et 100°C, selon une durée qui peut être par exemple de l'ordre de plusieurs dizaines de minutes.

Des étapes de pressage pour solidariser les bandes à l'aide d'un liant, par exemple du PEG (polyéthylène glycol), ou du PVB (polyvinyl butyral), puis de déliantage peuvent être également effectuées. Une étape de frittage visant à consolider l'empilement par apport d'énergie thermique peut également être mise en oeuvre. Cette étape peut être réalisée sous charge. Lors de l'étape de frittage, l'assemblage de bandes peut être amené à une température pouvant atteindre plus de 1000°C. Pour créer la cavité 25, il est possible d'utiliser une méthode d'empilement comprenant une technique communément appelée LTCC (pour « low temperature co-fired ceramic ») ou encore HTCC (« high temperature co-fired ceramic »), la technique LTCC étant généralement réalisée pour des températures en dessous de 1000°C, tandis que la technique HTCC est effectuée pour des températures voisines de 1600°C-1700°C.

Comme indiqué précédemment, un moyen de soutien mécanique tel qu'un matériau sacrificiel dans la cavité 25 et/ou des piliers dans la cavité 25 peuvent être prévus pour éviter un affaissement de l'enveloppe diélectrique formant la cavité 25 lors des étapes d'assemblage des feuillets de céramique crue et/ou de frittage.

Pour réaliser des ouvertures 70a, 70b, 70c, 70d d'entrée(s)/sortie(s) dans l'enveloppe diélectrique du support 22, on peut ensuite réaliser un perçage par exemple par laser.

L'assemblage avec le support diélectrique 22 de couches dans lesquelles les zones conductrices 20a, 20b, 20c sont prévues peut être quant à lui réalisé par exemple par assemblage direct.

Lorsque les zones conductrices 20a, 20b, 20c sont à base de cuivre et le support 20 en matériau céramique, un assemblage du type de celui décrit par exemple dans le document : « Eutectic bonding of copper to ceramics for thermal dissipation applications », de Tuan et al., a review Journal of the European Ceramic Society 34(2014) 4117-4130 peut être prévu. Dans ce cas, on réalise une oxydation d'une couche de cuivre, puis on met en contact une zone de cuivre oxydé (CuO) avec un matériau céramique tel que par exemple de l'Al₂O₃ à une température par exemple de l'ordre de 1065°C pendant une durée par exemple de l'ordre de 3 min afin de former un composé CuAlₓO_{y} permettant de lier la céramique du support au cuivre de la zone conductrice.

Le remplissage de la cavité 25 par du matériau à changement de phase 26 peut n'être réalisé qu'une fois avoir revêtu le support diélectrique 22 d'une ou plusieurs couches ou zones conductrices 20a, 20b, 20c avantageusement en cuivre.

Dans ce cas, on effectue le remplissage par le biais d'ouvertures latérales comme dans l'exemple illustré sur les figures 3A-3B et/ou d'ouvertures transversales traversant une zone conductrice comme dans l'exemple illustré sur la figure 4.

Pour permettre d'améliorer le remplissage de la cavité par le matériau à changement de phase 26, on peut prévoir, préalablement à ce remplissage (figure 7A), de tapisser les parois internes de la cavité 25 d'une fine couche 73 appelée « liner », à base d'un matériau, qui présente une affinité avec le matériau à changement de phase 26. Le liner 73 peut être à base d'un matériau métallique tel que par exemple de l'étain, ou du titane, ou de l'or, présentant une affinité avec un matériau à changement de phase 26 métallique.

Ce liner 73 peut être réalisé par exemple par dépôt de type PVD (pour « physical vapor deposition »), ou CVD (pour « chemical vapor deposition ») ou par évaporation ou par une technique de MOCVD (pour « metalorganic chemical vapor deposition »).

Plus généralement, un liner 73 à base d'un matériau tel qu'un matériau métallique ayant de bonnes propriétés de conduction thermique peut être disposé contre l'enveloppe diélectrique à l'intérieur de la cavité 25, afin de permettre une meilleure répartition de chaleur autour du matériau à changement de phase (figure 7B).

Après le remplissage de la cavité (25) par du matériau à changement de phase 26, on peut réaliser, comme cela est illustré sur la figure 8, un bouchage des ouvertures ayant servi au remplissage. On réalise ainsi des bouchons 84 localisés en regard et/ou dans les ouvertures. Ces bouchons peuvent être par exemple à base d'un matériau polymère.

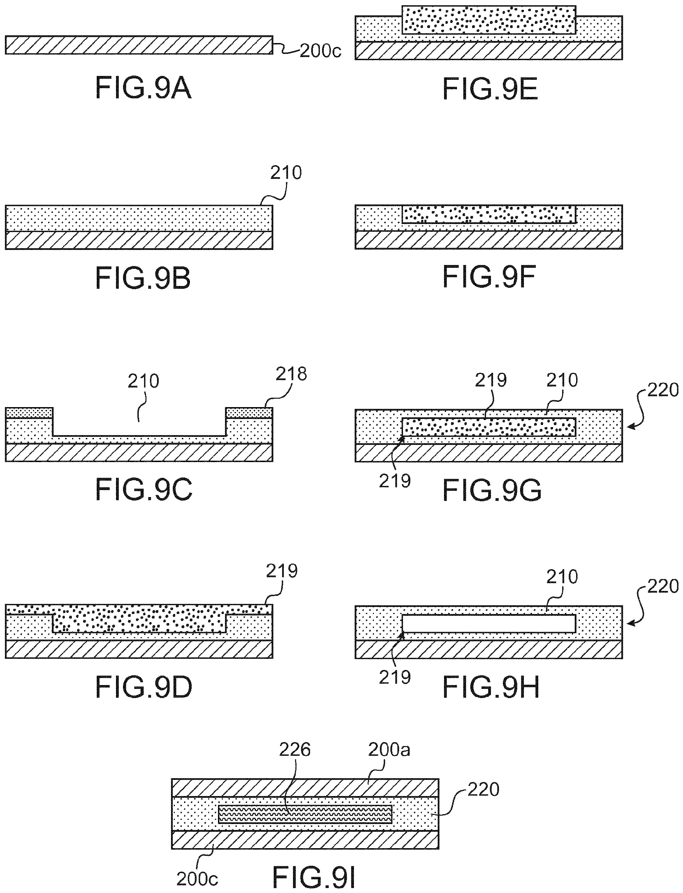

Une structure de type DBC telle que décrite précédemment peut être également réalisée à l'aide d'un procédé de réalisation en couches minces tel qu'illustré par exemple sur les figures 9A-9J.

Dans l'exemple de la figure 9A, on se sert d'une couche conductrice 200c par exemple à base de cuivre comme d'un substrat de départ. Cette couche conductrice 200c peut être par exemple celle destinée à accueillir l'élément dissipateur thermique 31 de la structure DBC.

Ensuite (figure 9B), on dépose sur ce substrat une ou plusieurs couches de matériau diélectrique 210, par exemple du Si₃N₄, ou en matériau céramique tel que l'AIN ou de l'Al₂O₃, dans lequel support isolant de la structure DBC est destiné à être formé.

Puis (figure 9C), on réalise une cavité 215 dans la ou les couche(s) de matériau diélectrique 210. Cette cavité 215 peut être réalisée par gravure à travers une ouverture d'un masque 218 formé sur le matériau diélectrique 210. La gravure peut être réalisée par plasma, en particulier de type RIE (pour « reactive ion etching ») ou par voie humide à l'aide d'un bain chimique. Dans le cas où le matériau diélectrique 210 est de l'AIN, le bain chimique peut être par exemple à base de KOH. En variante, la cavité 215 peut être formée à l'aide d'un procédé de type lift-off, dans lequel on effectue tout d'abord un dépôt de résine photosensible pleine plaque sur la couche conductrice 200c, puis on expose cette couche uniquement sur les bords en protégeant la partie centrale à l'aide d'un masque, et on retire ensuite la résine insolée à l'aide d'un bain chimique. On effectue ensuite un dépôt du diélectrique 210 à base par exemple d'AIN, ou de Si₃N₄. On retire ensuite la résine restante non-insolée, à l'aide par exemple d'un bain à l'acétone qui permet ne pas dissoudre le matériau diélectrique 210.

Une fois la cavité 215 réalisée, on dépose ensuite un matériau sacrificiel 219 dans celle-ci (figure 9D). Le matériau sacrificiel 219 peut être un matériau photosensible apte à être gravé ou être dissout chimiquement. On peut prévoir comme matériau sacrificiel 219 une résine photosensible par exemple de type S1818™, S1828™, SU8™ formée par exemple par dépôt tournant (« spin-coating » selon la terminologie anglo-saxonne).

Des étapes de retrait du masque 218 de gravure, puis de portions de matériau sacrificiel 219 en excès débordant de l'embouchure de cavité 215 peuvent être ensuite réalisées (figures 9E et 9F).

Puis, on ferme la cavité 215 par dépôt d'au moins une couche supplémentaire du matériau diélectrique 210 (figures 9G).

On peut ensuite réaliser des ouvertures latérales et/ou transversales (non représentées) d'accès à la cavité 215 par perçage du matériau diélectrique, en particulier à l'aide d'un laser ou bien par photolithographie.

Puis, on retire le matériau sacrificiel 219 de la cavité 215. Pour cela, l'ensemble peut être par exemple immergé dans un bain chimique tel que par exemple du MF319™ ou du PGMEA (2-methoxy-1-methylethylacetate) pour dissoudre la résine photosensible.

Le remplissage de la cavité 215 peut être ensuite réalisé par dispense d'un matériau à changement de phase 226 porté à une température supérieure à sa température de fusion.

Puis, on forme une autre zone conductrice 200a, par exemple à base de cuivre sur le support 220 de matériau diélectrique 210 (figure 9I). Cette autre zone conductrice 200a est disposée sur une face du support opposée à celle sur laquelle se trouve la zone conductrice 200c ayant servi de substrat de départ. La zone conductrice 200a peut être réalisée par exemple par dépôt PVD. Une telle technique peut être réalisée avantageusement à température ambiante et permettre ainsi d'éviter de soumettre la structure contenant le matériau à changement de phase 226 à une température trop importante.

On peut prévoir de se servir de la zone conductrice 200a comme zone de fermeture des ouvertures réalisées dans l'enveloppe de matériau diélectrique 210 afin de la remplir de matériau à changement de phase, en particulier lorsque ces ouvertures sont des ouvertures transversales réalisées sur la face supérieure du support diélectrique.

En variante de l'exemple de réalisation décrit précédemment en liaison avec les figures 9G-9I, on assemble la zone conductrice 200a sur le support de matériau diélectrique 210 avant d'effectuer le remplissage de la cavité par du matériau à changement de phase 226. Dans ce cas, un bouchage des ouvertures de remplissage par le biais de bouchons formés en regard des ouvertures ou dans les ouvertures peut être effectué.

## Revendications

1. Procédé de réalisation d'une structure de connexion et de dissipation de la chaleur issue d'un dispositif électronique (1), la structure comprenant : un support diélectrique (22) apte à être revêtu d'au moins une zone conductrice (20a) en contact avec une première face du support, la zone conductrice (20a) étant prévue pour accueillir le dispositif électronique (1), le support isolant (22) étant apte à être revêtu d'au moins une autre zone conductrice (20c) en contact avec une deuxième face du support opposée à la première face, l'autre zone conductrice (20c) étant apte à accueillir un échangeur thermique, le support isolant (22) comportant une enveloppe en matériau diélectrique délimitant une cavité (25) remplie d'un matériau à changement de phase, le procédé comprenant des étapes de :
a) formation d'un support isolant (22) comprenant une enveloppe de matériau diélectrique définissant une cavité (25), une ou plusieurs ouvertures (40a, 40b, 40c, 40d) étant formées dans l'enveloppe de sorte à permettre un accès à la cavité (25),
b) remplissage de la cavité (25) à l'aide d'un matériau (26) à changement de phase introduit à travers au moins une desdites ouvertures.

2. Procédé selon la revendication 1, dans lequel la cavité (25) formée à l'étape a) est remplie d'un matériau sacrificiel (69, 219), les ouvertures étant formées de sorte à accéder au matériau sacrificiel, le procédé comprenant en outre entre l'étape a) et l'étape b) une étape de retrait du matériau sacrificiel, le matériau sacrificiel étant remplacé à l'étape b) par le matériau (26) à changement de phase.

3. Procédé selon l'une des revendications 1 ou 2, dans lequel l'étape a) comprend la formation d'un ou plusieurs piliers de soutien (59) de l'enveloppe de matériau diélectrique, le ou les piliers (59) s'étendant dans la cavité (25) entre la première face et la deuxième face du support (22) isolant.

4. Procédé selon l'une des revendications 1 à 3, dans lequel l'enveloppe de matériau diélectrique est revêtue à l'intérieur de la cavité (25) d'une couche à base d'un matériau conducteur thermique, en particulier métallique (73).

5. Procédé selon l'une des revendications 1 à 4, dans lequel au moins une ouverture (40a, 40b) parmi lesdites une ou plusieurs ouvertures est formée à travers une face latérale du support (22) isolant, la face latérale reliant la première face et la deuxième face du support (22).

6. Procédé selon l'une des revendications 1 à 5, dans lequel parmi lesdites une ou plusieurs ouvertures au moins une ouverture (40c, 40d) traverse la première ou la deuxième face du support (22) isolant.

7. Procédé selon l'une des revendications 1 à 6, comprenant en outre après l'étape b) de remplissage : la formation d'un ou plusieurs éléments (84) de bouchage desdites ouvertures (40a, 40b, 40c, 40d).

8. Procédé selon l'une des revendications 1 à 7, dans lequel le matériau diélectrique de l'enveloppe s'étend sur la première face, la deuxième face et sur des faces latérales disposées entre la première face et la deuxième face.

9. Procédé selon l'une des revendications 1 à 8, comprenant au moins une étape de formation d'une zone conductrice (20a, 20c) sur le support (22) isolant.

10. Structure, en particulier de type DBC, de connexion et de dissipation de la chaleur issue d'un dispositif électronique (1), comprenant : un support isolant (22) revêtu d'au moins une zone conductrice (20a) en contact avec une première face du support, la zone conductrice (20a) étant prévue pour accueillir le dispositif électronique (1), le support isolant (22) étant revêtu d'au moins une autre zone conductrice (20c) en contact avec une deuxième face du support opposée à la première face, l'autre zone conductrice (20c) étant apte à accueillir un échangeur thermique, le support isolant comprenant une enveloppe de matériau diélectrique définissant une cavité (25), la cavité (25) étant remplie d'un matériau à changement de phase.

11. Structure selon la revendication 10, comprenant en outre un ou plusieurs piliers de soutien (59) de l'enveloppe de matériau diélectrique, le ou les piliers (59) s'étendant dans la cavité (25) entre la première face et la deuxième face du support (22) isolant.

12. Structure selon l'une des revendications 10 ou 11, dans lequel l'enveloppe de matériau diélectrique est revêtue à l'intérieur de la cavité (25) d'une couche à base d'un matériau conducteur thermique, en particulier métallique (73).

## Patentansprüche

1. Verfahren zur Umsetzung einer Struktur zum Verbinden und zum Abführen von Wärme, die von einer elektronischen Vorrichtung (1) ausgegeben wurde, wobei die Struktur aufweist: einen dielektrischen Träger (22), der in der Lage ist, von zumindest einem leitenden Bereich (20a) in Kontakt mit einer ersten Trägerfläche überzogen zu sein, wobei der leitende Bereich (20a) vorgesehen ist, um die elektronische Vorrichtung (1) aufzunehmen, wobei der Isolierträger (22) in der Lage ist, mit zumindest einer weiteren leitenden Bereich (20c) in Kontrakt mit einer zweiten Trägerfläche, die zur ersten Fläche entgegengesetzt liegt, überzogen zu sein, wobei die weitere leitende Bereich (20c) in der Lage ist, einen Wärmetauscher aufzunehmen, wobei der Isolierträger (22) eine Umhüllung aus einem dielektrischen Material aufweist, die einen Hohlraum (25) begrenzt, der mit einem Phasenänderungsmaterial gefüllt ist, wobei das Verfahren die folgenden Schritte aufweist:
a) Bilden eines Isolierträgers (22), der eine Umhüllung aus dielektrischem Material aufweist, die einen Hohlraum (25) definiert, wobei eine oder mehrere Öffnungen (40a, 40b, 40c, 40d) in der Umhüllung in einer solchen Weise ausgebildet ist/sind, dass diese einen Zugang zum Hohlraum (25) gestatten,
b) Auffüllen des Hohlraums (25) vermittels eines Phasenänderungsmaterials (26), das vermittels zumindest eine der Öffnungen eingeführt wird.

2. Verfahren nach Anspruch 1, wobei der Hohlraum (25), der in Schritt a) gebildet wird, mit einem Opfermaterial (69, 219) gefüllt wird, wobei die Öffnungen in der Art gebildet werden, dass zum Opfermaterial gelangt wird, wobei das Verfahren ferner zwischen Schritt a) und Schritt b) einen Schritt des Zurückziehens des Opfermaterials aufweist, wobei das Opfermaterial in Schritt b) durch das Phasenänderungsmaterial (26) ersetzt wird.

3. Verfahren nach Anspruch 1 oder 2, wobei Schritt a) das Ausbilden von einer Stützsäule oder mehreren von diesen (59) der Umhüllung aus dielektrischem Material aufweist, wobei die Säule oder die Säulen (59) sich in den Hohlraum (25) zwischen der ersten Fläche und der zweiten Fläche des Isolierträgers (22) erstreckt/erstrecken.

4. Verfahren nach einem der Ansprüche 1 bis 3, wobei die Umhüllung aus dielektrischem Material im Inneren des Hohlraums (25) von einer Schicht auf der Grundlage von einem Wärmeleitmaterial, insbesondere metallischem (73), überzogen ist.

5. Verfahren nach einem der Ansprüche 1 bis 4, wobei zumindest eine Öffnung (40a, 40b) von der oder den einen oder mehreren Öffnungen vermittels einer Seitenfläche des Isolierträgers (22) gebildet wird, wobei die Seitenfläche die erste Fläche und die zweite Fläche des Trägers (22) verbindet.

6. Verfahren nach einem der Ansprüche 1 bis 5, wobei von der einen oder mehreren Öffnungen zumindest eine Öffnung (40c, 40d) die erste oder zweite Fläche des Isolierträgers (22) durchquert.

7. Verfahren nach einem der Ansprüche 1 bis 6, das ferner nach Schritt b) des Auffüllens das Ausbilden von einem oder mehreren der Elemente (84) zum Verschließen der Öffnungen (40a, 40b, 40c, 40d) aufweist.

8. Verfahren nach einem der Ansprüche 1 bis 7, wobei das dielektrische Material der Umhüllung sich über die erste Fläche, die zweite Fläche und über die Seitenflächen, die zwischen der ersten Fläche und der zweiten Fläche angeordnet sind, erstreckt.

9. Verfahren nach einem der Ansprüche 1 bis 8, das zumindest einen Schritt des Ausbildens eines leitenden Bereiches (20a, 20c) auf dem Isolierträger (22) aufweist.

10. Struktur, insbesondere vom DBC-Typ, zum Verbinden und Abführen von Wärme, die von einer elektronischen Vorrichtung (1) ausgegeben wurde, die aufweist: einen Isolierträger (22), der mit zumindest einem leitenden Bereiche (20a) in Kontakt mit einer ersten Stützfläche überzogen ist, wobei der leitende Bereich (20a) vorgesehen ist, um die elektronische Vorrichtung (1) aufzunehmen, wobei der Isolierträger (22) mit zumindest einem weiteren leitenden Bereich (20c) in Kontakt mit einer zweiten Stützfläche, die zur ersten Fläche entgegengesetzt liegt, überzogen ist, wobei der weitere leitende Bereich (20c) in der Lage ist, einen Wärmetauscher aufzunehmen, wobei der Isolierträger eine Umhüllung aus dielektrischem Material aufweist, die einen Hohlraum (25) definiert, wobei der Hohlraum (25) mit einem Phasenänderungsmaterial gefüllt ist.

11. Struktur nach Anspruch 10, die ferner eine Stützsäule oder mehrere von diesen (59) der Umhüllung aus dielektrischem Material aufweist, wobei die Säule oder Säulen (59) sich in dem Hohlraum (25) zwischen der ersten Fläche und der zweiten Fläche des Isolierträgers (22) erstreckt/erstrecken.

12. Struktur nach Anspruch 10 oder 11, wobei die Umhüllung aus dielektrischem Material im Inneren des Hohlraums (25) mit einer Schicht auf der Grundlage eines wärmeleitenden Materials, insbesondere eines metallischen (73), überzogen ist.

## Claims

1. A manufacturing method for a structure configured to connect and for dissipate the heat produced by an electronic device (1), the structure comprising: a dielectric support (22) configured to be coated with at least one conductive zone (20a) in contact with a first face of the support, the conductive zone (20a) being adapted to receive the electronic device (1), the insulating support (22) being further configured to be coated with at least one other conductive zone (20c) in contact with a second face of the support opposed to the first face, the other conductive zone (20c) being able to receive a heat exchanger, the insulating support (22) comprising an envelope made of dielectric material forming the outer limits of a cavity (25) filled with a phase change material, the method comprising steps for:
a) forming of an insulating support (22) comprising an envelope of dielectric material defining a cavity (25), one or more openings being formed in the envelope so as to allow access to the cavity,
b) filling the cavity (25) using a phase change material (26) introduced through at least one of said openings.

2. The method according to claim 1, wherein the cavity (25) formed during step a) is filled with a sacrificial material (69, 219), the openings being formed so as to access the sacrificial material, the method further comprising between step a) and step b) a step of removing the sacrificial material, the sacrificial material being replaced at step b) by the phase change material (26).

3. The method according to any of the claims 1 or 2, wherein step a) comprises the formation of one or more support columns (59) for the envelope of dielectric material, the column or columns (59) extending in the cavity (25) between the first face and the second face of the insulating support (22).

4. The method according to any of the claims 1 to 3, wherein the envelope of dielectric material is coated inside the cavity (25) by a layer made of thermally conductive material, in particular metallic (73).

5. The method according to any of the claims 1 to 4, wherein at least one opening (40a, 40b) amongst said one or more openings is formed through a lateral face of the insulating support (22), with the lateral face attached to the first face and the second face of the support (22).

6. The method according to any of the claims 1 to 5, wherein amongst said one or more openings at least one opening (40c, 40d) passes through the first or the second face of the insulating support (22).

7. The method according to any of the claims 1 to 6, further comprising after filling step b): forming one or more elements (84) for capping said openings (40a, 40b, 40c, 40d).

8. The method according to any of the claims 1 to 7, wherein the dielectric material of the envelope extends over the first face, and the second face, and onto the lateral faces placed between the first face and the second face.

9. The method according to any of the claims 1 to 8, further comprising at least one step for forming of a conductive zone (20a, 20c) on the insulating support (22).

10. A Structure, of the DBC type, for connection and for dissipation of the heat produced by an electronic device (1), comprising an insulating support (22), the insulating support being coated with:
- at least one conductive zone (20a) in contact with a first face of the support, the conductive zone (20a) being configured to receive the electronic device (1),
- at least one other conductive zone (20c) in contact with a second face of the support opposed to the first face, the other conductive zone (20c) being configured to receive a heat exchanger, the insulating support further comprising an envelope of dielectric material which defines a cavity (25), the cavity (25) being filled with a phase change material.

11. The structure according to claim 10 further comprising one or more support columns (59) for the envelope of dielectric material, the column or columns (59) extending in the cavity (25) between the first face and the second face of the insulating support (22).

12. The structure according to any of the claims 10 or 11, wherein the envelope of dielectric material is coated inside the cavity (25) by a layer made of thermally conductive material, in particular metallic (73).
